Europäisches Patentamt

(19) European Patent Office

Office européen des brevets

(11) Numéro de publication: **0 118 352**
**B1**

(12) # FASCICULE DE BREVET EUROPÉEN

(45) Date de publication du fascicule du brevet:
29.04.87

(51) Int. Cl.⁴: **C 01 G 13/04, C 30 B 7/06**

(21) Numéro de dépôt: **84400347.5**

(22) Date de dépôt: **20.02.84**

(54) **Procédé de préparation d'iodure mercurique alpha de haute pureté destiné à être utilisé comme source de matière première pour la croissance de monocristaux pour la détection nucléaire.**

(30) Priorité: **28.02.83 FR 8303262**

(43) Date de publication de la demande:
**12.09.84 Bulletin 84/37**

(45) Mention de la délivrance du brevet:
**29.04.87 Bulletin 87/18**

(84) Etats contractants désignés:
**DE GB NL**

(56) Documents cité:
**EP-A-0 022 013**
**DE-A-2 655 736**
**FR-A-2 316 192**
**FR-A-2 338 742**
**US-A-3 969 182**

(73) Titulaire: **COMMISSARIAT A L'ENERGIE ATOMIQUE Etablissement de Caractère Scientifique Technique et Industriel, 31/33, rue de la Fédération, F-75015 Paris (FR)**

(72) Inventeur: **Nicolau, Yann Florent, Le Brinchet Cidex 634, F-38330 Saint- Nazaire- lès- Eymes (FR)**

(74) Mandataire: **Mongrédien, André, c/o BREVATOME 25, rue de Ponthieu, F-75008 Paris (FR)**

## Description

La présente invention a pour objet un procédé de préparation d'iodure mercurique alpha de haute pureté, destiné à être utilisé comme source de matière première pour la croissance de monocristaux d'iodure mercurique alpha utilisables pour la fabrication des détecteurs et des spectromètres de radiations X et gamma, travaillant à la température ambiante.

Pour la réalisation de détecteurs et de spectrophotomètres de radiations X et gamma, il est nécessaire de disposer d'iodure mercurique alpha de haute pureté pour obtenir par croissance des monocristaux de $\alpha$-HgI$_2$ non déformés et présentant un haut degré de pureté et une stoechiométrie parfaitement contrôlée. En effet, pour obtenir des performances satisfaisantes, il est important d'éviter que le monocristel ne présente des centres de capture ayant des niveaux profonds dans la bande interdite, car les porteurs de charge peuvent être captés par ces centres à niveaux profonds.

Ces derniers sont généralement dus à un écart par rapport à la stoechiométrie du monocristal, à des déformations plastiques (disloxations) et à l'inclusion d'impuretés engendrés lors de la croissance du monocristal.

Le brevet allemand DE-A- 2 655 736 décrit un procédé de purification de matières inorganiques telles que l'iodure mercurique, qui consiste à chauffer la matière dans un système fermé à une température de 350°C pendant au moins une semaine pour que les impuretés organiques ayant des pressions de vapeurs similaires soient décomposées, et à soumettre ensuite la matière à un processus de purification tel qu'une distillation.

On connaît un procédé de fabrication de monocristaux de $\alpha$-HgI$_2$ qui permet à la fois de contrôler la stoechiométrie du monocristal et de minimiser les déformations plastiques. Ce procédé décrit dans la demande de brevet européen EP-A- 0 022 013 du 23 juin 1980, utilise comme matière première des polycristaux d'iodure mercurique alpha et une solution de HgI$_2$ dans un sulfoxyde organique et du méthanol qui a été purifié préalablement par électrolyse.

Bien que ce procédé conduise à l'obtention de cristaux ayant des propriétés satisfaisantes, il est cependant souhaitable d'améliorer encore les propriétés des monocristaux en utilisant pour la croissance des polycristaux présentant un degré de pureté plus élevé, car dans les polycristaux obtenus par des procédés de synthèse classiques à partir d'éléments ayant un haut degré de pureté, le contenu des impuretés de nature métallique, métalloïdique et organique est encore trop élevé.

On connaît également un procédé de purification de $\alpha$-HgI$_2$ destiné à être utilisé pour la croissance de cristaux de haute qualité. Ce procédé décrit dans la demande de brevet français FR-A- 2 316 192 comprend trois étapes:
- une première étape de synthèse de l'iodure mercurique à partir de mercure et d'iode,
- une seconde étape de purification par sublimation répétée de l'iodure mercurique préparé par synthèse, et
- une troisième étape de purification par fusion de zone de l'iodure mercurique purifié par sublimation.

Cependant, ce procédé présente de nombreux inconvénients.

a) Il est impossible d'obtenir de grandes quantités de $\alpha$-HgI$_2$ lors de la synthèse à sec, en raison du danger d'explosion, et de ce fait les quantités de $\alpha$-HgI$_2$ préparées par ce procédé sont limitées à 100 g par charge.

b) Le nombre élevé d'étapes de sublimation et de fusion de zone donne lieu à des difficultés de mise en oeuvre et conduit à un faible rendement. En effet, pour avoir un bon degré de pureté, il est nécessaire d'effectuer 6 à 30 sublimations successives et 30 à 100 fusions de zones.

c) L'efficacité de séparation des impuretés est faible dans l'étape de sublimation car, à la température de sublimation comprise entre 100 et 140°C, la plupart des impuretés organiques forment des complexes stables avec $\alpha$-HgI$_2$, qui ont une pression de vapeur comparable à celle d'$\alpha$-HgI$_2$. De ce fait, ces complexes se subliment et se condensent en même temps que $\alpha$-HgI$_2$. De même, les impuretés organiques ne se décomposent que partiellement à la température utilisée pour la sublimation. Ainsi, les analyses par spectrométrie de masse ont montré que dans des monocristaux d'iodure mercurique alpha purifié par des sublimations répétées, obtenus par croissance en phase vapeur, il restait au moins dix éléments (C, N, O, Al, Ca, Mn, Na, K, Cr et Fe) et des impuretés organiques se décomposant en sept radicaux hydrocarbonés (CH$_3$, C$_2$H$_3$, C$_3$H$_3$, C$_3$H$_4$, C$_4$H$_4$, C$_4$H$_7$ et C$_4$H$_8$) à des concentrations relativement élevées puisqu'elles dépassent en moyenne 50 à 100 ppm atomiques pour chaque élément ou radical hydrocarboné.

d) La fusion de zone est difficile à réaliser en raison de la pression de vapeur élevée de HgI$_2$ fondu d'autant plus que le HgI$_2$ purifié par sublimation contient beaucoup d'impuretés organiques qui craquent et donnent des suspensions de carbone et de goudron impossibles à séparer par fusion de zone, et des produits gazeux qui risquent par surpression de faire éclater le tube scellé contenant HgI$_2$ à purifier.

On connaît également un autre procédé de purification qui comporte trois étapes:
- une première étape de purification par recristallisation à partir d'une solution d'HCl (1 : 1) saturée en $\alpha$-HgI$_2$ à environ 100°C,
- une seconde étape de purification par distillation "thermo-chimique" (évaporation à environ 200°C sous vide, surchauffe de la vapeur d'HgI$_2$ à 400-500°C et condensation du $\alpha$-HgI$_2$ à 40-50°C),
- une troisième étape de purification par sublimations répétées à 120-130°C,

Cependant, ce procédé présente également de nombreux inconvénients:
a) le produit résultant est pollué par le chlore,
b) le produit résultant est non stoechiométrique (riche en Hg),
c) le procédé nécessite 6-8 cycles finals de sublimation avec une vitesse très faible de 2g/heure, ayant un

2

rendement total de 10-12 %.

La présente invention a précisément pour objet un procédé de préparation d'iodure mercurique alpha de haute pureté qui pallie les inconvénients des procédés rappelés ci-dessus et permet l'élimination des impuretés de toutes natures (métalliques, métalloïques et organiques) avec un bon rendement, tout en étant adapté à une mise en oeuvre à l'échelle industrielle.

Le procédé selon l'invention, de préparation d'iodure mercurique alpha de haute pureté, se caractérise en ce qu'il consiste:

a) à synthétiser de l'iodure mercurique alpha, et

b) à soumettre l'iodure mercurique alpha ainsi obtenu à un traitement de purification comprenant au moins une étape de distillation sous vide, à une température d'au moins 255°C, réalisée dans un réacteur comportant trois zones successives, maintenues à des températures différentes, constituées respectivement par une première zone maintenue à la température du point triple de l'$\alpha$-HgI$_2$, soit à 255°C, dans laquelle on introduit l'iodure mercurique alpha à purifier, une deuxième zone maintenue à une température de 255 à 300°C et une troisième zone maintenue à une température inférieure à celles des deux autres zones pour réaliser la condensation de l'iodure mercurique alpha évaporé, ladite troisième zone étant refroidie par de l'air et le réacteur étant maintenu sous vide au moyen d'une pompe à vide.

En fin de distillation on récupère l'$\alpha$-HgI$_2$ que s'est cristallisé sur les parois de la troisième zone du réacteur. Généralement, on réalise plusieurs cycles de distillation en utilisant pour chaque cycle l'iodure mercurique alpha cristallisé obtenu par condensation dans le cycle précédent. Le nombre de cycles est habituellement de 6 à 12.

Grâce à la mise en oeuvre de cette étape de distillation sous vide à une température de 255°C, on peut éliminer la plupart des impuretés et contrôler simultanément la composition stoechiométrique de l'iodure mercurique.

En effet, la plupart des impuretés anorganiques qui se trouvent sous la forme de complexes avec HgI$_2$ et ont une pression de vapeur comparable à celle de HgI$_2$, se dissocient entre 255 et 300°C et leur pression de vapeur devient alors très inférieure à la pression de vapeur de HgI$_2$; par conséquent, ces impuretés restent sous la forme de résidu dans le fond du réacteur et sur la paroi latérale de celui-ci. De même, les impuretés organiques se décomposent à cette température, les gaz tels que H$_2$, H$_2$O, N$_2$, NH$_3$, CH$_4$, CO, CO$_2$ etc... sont pompés par la pompe à vide, et le carbone ou certains goudrons restent dans le résidu. De plus, la distillation qui est basée sur la difference entre les pressions partielles des impuretés et du HgI$_2$ est plus efficace que la sublimation qui se base uniquement sur la différence entre les pressions de vapeur des impuretés et du HgI$_2$.

Il en résulte que la distillation est très efficace pour éliminer dans le résidu:
- Li, Na, K, Mg, Ca, Cr (II), Mn, Ni, Co, Ag, Ba et Pb, sous la forme d'iodures,
- Al et Si, sous la forme de silicates,
- B sous la forme de borate, P sous la forme de phosphate et As sous la forme d'arséniate, et
- Ti, Zr et V sous la forme d'oxydes.

De même, la distillation est efficace pour séparer également dans le résidu Fe (III), Cu (I), Zn, Cd et Sn (II), sous la forme d'iodures, et S et Se respectivement sous la forme de HgS et de HgSe.

Le phosphore, le bore et l'iode étant très volatils, ceux-ci se retrouvent condensés dans le piège refroidi à l'azote liquide se trouvant entre la pompe et le réacteur, respectivement sous la forme de PI$_3$, BI$_3$ et I$_2$.

Le fluor, le chlore et le brome qui se trouvent sous la forme d'halogénures de mercure qui sont plus volatils que HgI$_2$, se condensent partiellement dans le piège. Il en est de même pour le titane, l'étain (IV) et le mercure (I) qui se trouvent sous la forme d'iodures.

La distillation est moins efficace pour la séparation d'Al, Si, Cr$^{III}$, As, V et Zr se trouvant sous forme d'iodures puisque ces iodures ont des pressions de vapeurs comparables avec l'HgI$_2$.

Ainsi, le procédé de l'invention présente une très bonne efficacité.

Selon une caractéristique avantageuse du procédé de l'invention, on réalise la synthèse de l'iodure mercurique alpha par réaction de mercure avec de l'iode, dans une solution d'un sulfoxyde organique contenant du méthanol.

Cette réaction est effectuée à la température ambiante, environ 20°C, dans un réacteur en quartz pour les semi-conducteurs. On utilise du mercure de haute pureté, par exemple d'une pureté m7N et de l'iode de haute pureté, par exemple d'une pureté m5N5, dissous dans une solution de sulfoxyde organique de pureté spectrophotométrique avec du méthanol de pureté électronique. Pour éviter l'échauffement de la solution, on refroidit à l'eau sous agitation et on ajoute progressivement le mercure jusqu'à l'épuisement de l'iode.

De préférence, la solution contient un excès d'iode par rapport à la quantité nécessaire pour obtenir du HgI$_2$ stoechiométrique.

Avantageusement, le rapport molaire [sulfoxyde organique]/[sulfoxyde] + [méthanol] est de 0,6 à 0,8 dans la solution utilisée pour cette synthèse.

En fin d'opération, on obtient ainsi une solution saturée de HgI$_2$ à partir de laquelle on peut récupérer HgI$_2$ par des procédés classiques, par exemple par précipitation à l'eau, en vue d'assurer ensuite sa purification par distillation.

Bien que la synthèse décrite ci-dessus soit préférée pour l'obtention d'un bon degré de pureté, on peut selon l'invention, synthétiser l'iodure mercurique alpha par d'autres procédés, par exemple, par synthèse en solution aqueuse, par réaction de double échange ou encore par synthèse à sec.

Selon l'invention le produit obtenu est ensuite soumis à un traitement de purification comprenant au moins une étape de distillation sous vide.

De préférence, selon l'invention, avant de réaliser cette étape de distillation, on soumet l'iodure mercurique alpha à une étape intermédiaire de purification électrolytique, en solution dans un sulfoxyde organique et/ou à une étape intermédiaire de recristallisation de l'iodure mercurique alpha à partir d'une solution d'iodure mercurique dans un sulfoxyde organique.

Les solutions utilisées pour la purification électrolytique et pour la recristallisation contiennent du méthanol, comme la solution utilisée pour la synthèse. Pour la purification électrolytique, l'addition de méthanol est telle que le rapport molaire [sulfoxyde]/[sulfoxyde] + [méthanol] soit de 0,6 à 0,9. Aussi, l'étape de purification électrolytique peut être effectuée directement sur la solution saturée de $HgI_2$ obtenue lors de la synthèse en solution à partir de mercure et d'iode.

Selon l'invention, l'étape de purification électrolytique est effectuée de manière à obtenir un minimum de conductivité de la solution de moins de 100 $\mu Scm^{-1}$ à 20°C. Cette purification est réalisée avantageusement dans les conditions données dans la demande de brevet français 79/16.418 déposée le 26 juin 1979 par le C.E.A.

Selon une variante de l'invention, on peut utiliser pour la purification électrolytique une solution d'iodure mercurique alpha préparée en dissolvant dans un sulfoxyde organique et du méthanol, de l'iodure mercurique alpha microcristallin récupéré par précipitation à partir de la solution saturée de $HgI_2$ obtenue lors de la synthèse. Dans ce cas, on ajoute à la solution saturée de l'eau ultra-pure pour précipiter $HgI_2$, on sépare le précipité par filtration et on le sèche sous vide, par exemple à 80°C, en utilisant un recipient en quartz pour les semiconducteurs.

L'électrolyse est une étape efficiente de purification de $HgI_2$ de toutes ses impuretés dissociées électrolytiquement en solution. Les impuretés organiques provenant de l'I de synthèse n'étant pas dissociées électrolytiquement ne peuvent pas être séparées par électrolyse.

Pour obtenir un degré de pureté satisfaisant à la suite de l'étape de purification électrolytique, on réalise, de préférence, plusieurs cycles de séparation des cations et plusieurs cycles de séparation des anions, par exemple de 8 à 24 cycles de séparation des cations et de 2 à 6 cycles de séparation des anions.

Après cette étape de purification électrolytique, on récupère $\alpha$-$HgI_2$ par précipitation au moyen d'eau, comme cela a été décrit précédemment.

On soumet ensuite cet $\alpha$-$HgI_2$ à l'étape de distillation sous vide, de préférence après lui avoir fait subir un traitement intermédiaire de purification par recristallisation à partir d'une solution de sulfoxyde organique contenant du méthanol. Le rapport molaire [sulfoxyde]/[sulfoxyde] + [méthanol] est de préférence de 0,1 à 0,2. Généralement on réalise la recristallisation entre 65 et 15°C. Etant donné que l'augmentation de solubilité de $HgI_2$ dans la solution en fonction de la temperature est faible, on réalise cette recristallisation dans un réacteur comportant deux zones maintenues à des températures différentes, dont une première zone de dissolution chauffée à une température de 60 à 65°C et une seconde zone de cristallisation maintenue à une température inférieure à environ 20°C. Le réacteur utilisé peut être un réacteur en quartz pour les semiconducteurs ayant une double paroi. Le fond du réacteur contient l'iodure mercurique alpha à recristalliser et il est chauffé par de l'eau, et la partie latérale supérieure du réacteur est refroidie à l'eau froide. Ainsi, les cristaux de $\alpha$-$HgI_2$ se dissolvent sur le fond et cristallisent sur les parois latérales, formant une croute compacte de polycristaux ayant une taille moyenne de 2 à 3 mm. Le transport de masse s'établit naturellement par convection thermique.

De préférence, on ajoute à la solution de recristallisation un excès d'iode pour éviter la réduction de $HgI_2$ en $Hg_2I_2$. On élimine ainsi les impuretés solubles qui se concentrent en solution. Mais le Cu, l'Ag, le Br et le Cd s'éliminent plus difficilement. Il en est de même pour les iodures lourds organiques provenant de l'I de synthèse (ou $HgI_2$ matière première). On réalise généralement plusieurs cycles de recristallisation pour améliorer le degré de pureté et le nombre de ces cycles est habituellement de 3 à 6.

Selon l'invention, les sulfoxydes organiques susceptibles d'être utilisés dans la solution de synthèse, la solution de purification par électrolyse et la solution de purification par recristallisation sont des dialcoylsulfoxydes tels que le diméthylsulfoxyde (DMSO), le méthyléthylsulfoxyde, le diéthylsulfoxyde, le tétraméthylène sulfoxyde etc... Généralement, on utilise le diméthylsulfoxyde.

D'autres caractéristiques et avantages de l'invention apparaitront mieux à la lecture de l'exemple suivant, donné bien entendu à titre illustratif et non limitatif en référence aux dessins annexés sur lesquels:

- la figure 1 représente schématiquement l'appareillage utilisé pour la purification électrolytique,
- la figure 2 représente le dispositif utilisé pour assurer la purification par recristallisation, et
- la figure 3 représente schématiquement le réacteur utilisé pour la purification par distillation sous vide de $HgI_2$.

Cet exemple se rapporte à l'obtention d'iodure mercurique alpha de haute pureté par mise en oeuvre de la première étape de synthèse en solution de l'iodure mercurique, et des trois étapes de purification constituées respectivement par la purification électrolytique de la solution d'iodure mercurique alpha dans un sulfoxyde, la recristallisation de $\alpha$-$HgI_2$ à partir d'une solution de $HgI_2$ dans un sulfoxyde organique, et la distillation sous vide.

a) synthèse de $\alpha$-$HgI_2$

On réalise la synthèse de $\alpha$-$HgI_2$ dans un réacteur en quartz de 3 l muni d'un agitateur axial et d'un entonnoir de dégouttement qui traverse l'obturateur du réacteur. Le réacteur est pourvu d'une double paroi, ce qui permet d'assurer son refroidissement par de l'eau.

On introduit dans le réacteur 26,5 mol de (DMSO) pour la spectrophotométrie (produit Aldrich) dilué avec 6,5 mol de méthanol (MeOH) électronique, ce qui correspond à un rapport molaire [DMSO]/[DMSO] + [MeOH] de 0,8. On dissout 8 atomes-grammes d'iode de pureté m5N5 dans la solution, puis on ajoute progressivement et sous agitation 4 atomes-grammes de mercure de pureté m7N. Au fond du réacteur, le mercure réagit avec l'iode pour donner naissance à HgI₂ qui se dissout dans la solution. La réaction s'arrête lorsque l'un des deux éléments est épuisé. On ajoute alors un léger excès de mercure et on observe la fin de la réaction par virage de la couleur de la solution du brun au jaune paille. On ajoute alors à nouveau 8 atomes-grammes d'iode puis 4 atomes-grammes de mercure et en fin de réaction on ajoute encore 8 atomes-grammes d'iode et 4 atomes-grammes de mercure. Au bout de 24 heures, on obtient ainsi une solution contenant 12 mol de HgI₂.

Pour contrôler la stoechiométrie du HgI₂ ainsi obtenu, on ajoute en fin d'opération un léger excès d'iode (0,5 à 1 g), puis on filtre la solution sur un filtre à plaque filtrante en quartz ayant une porosité de 4 pour éliminer les traces d'impuretés blanches d'aspect graisseux qui flottent en surface (produits organiques).

On peut récupérer l'α-HgI₂ solide à partir de cette solution en le précipitant par addition de 250 mol d'eau ultrapure. Le précipité sédimente aisément; on le lave six fois avec 250 mol d'eau ultrapure, on l'égoutte sur un entonnoir à plaque filtrante en quartz et on le sèche à l'étuve à 60°C sous un vide de 1350 Pa pendant 46 heures. Dans le tableau joint (colonne 1), on a indiqué les teneurs en impuretés de l'iodure mercurique alpha ainsi préparé.

b) Purification par électrolyse.
Pour cette étape de purification, on redissout les cristaux d'α-HgI₂ dans une solution de DMSO et de MeOH.

On peut aussi utiliser directement la solution saturée d'iodure mercurique obtenue à la fin de l'étape de synthèse.

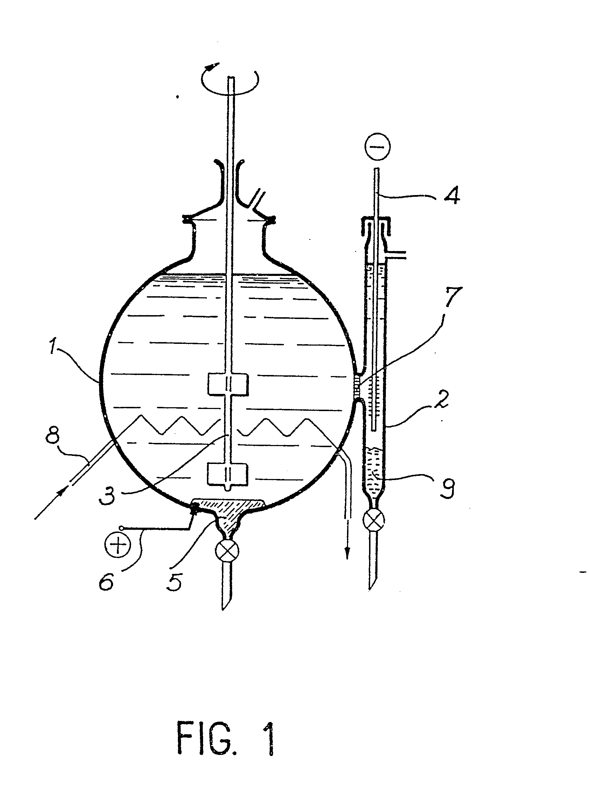

La purification est réalisée dans l'appareillage représenté sur la figure 1 qui comporte un ballon 1 en quartz de 10 litres constituant l'espace anodique de l'électrolyseur et un tube de quartz 2 de 100 ml de volume constituant l'espace cathodique de l'électrolyseur. Le compartiment anodique est muni d'un agitateur en quartz 3 et le compartiment cathodique est muni d'une cathode 4 en graphite.

L'anode du compartiment anodique est constituée par un excès de mercure 5 disposé au fond du ballon 1 et relié par un fil de tungstène 6 à un générateur de courant électrique continu. L'espace cathodique communique avec l'espace anodique par l'intermédiaire d'une plaque de quartz fritté 7 formant mmembrane. On introduit dans l'espace anodique la solution d'iodure mercurique à purifier et on applique entre les électrodes une tension de 200 V, tout en refroidissant la solution par de l'eau froide circulant dans un serpentin en quartz 8 qui traverse le ballon, afin de limiter la température à 20°C; le courant varie de 20 à 100 mA.

Dans ces conditions, le courant électrique est porté par les anions d'iodomercurate [HgI₃], par les cations d'impuretés, et dans une certaine mesure par des cations [HgI]⁺. Tous ces ions proviennent, soit de la complexation des iodures d'impuretés par l'iodure mercurique selon une réaction générale du type de la suivante pour l'iodure de sodium, par exemple:

NaI + HgI₂ → Na⁺ + [HgI₃]⁻

soit d'une certaine autocomplexation de l'iodure mercurique même selon la réaction:

2HgI₂ ⇄ [HgI]⁺ + [HgI₃]⁻

A l'anode, les anions d'iodomercurate se déchargent et délivrent de l'iode. Pour éviter la concentration de l'iode, on a mis au fond du ballon un excès de mercure 5 de haute pureté 7N, qui réagit avec l'iode en reformant l'iodure mercurique. Dans ce cas, pour éviter la sursaturation, on dilue la solution de temps en temps.

A la cathode, les cations d'impuretés se concentrent dans l'espace cathodique 2: par exemple Na⁺, K⁺, Fe³⁺, Ni²⁺, Cu²⁺, Cu⁺, Cr³⁺, Ca²⁺, Ag⁺, etc... Les cations [HgI]⁺ se déchargent en déposant une boue d'iodure mercureux insoluble 9. Certains cations d'impureté se déposent en même temps que la boue d'iodure mercureux ou s'adsorbent dans cette boue. La conductivité de l'espace cathodique augmente d'un ordre ou même de deux ordres de grandeur par la concentration des impuretés ionisées. On vidange alors l'espace 2 sous tension et on continue l'électrolyse. La conductivité de l'espace anodique diminue progressivement par suite de la purification et reste stationnaire à 110 μScm⁻¹ à 20°C, valeur approximative puisqu'elle est tributaire non seulement de l'autoionisation de l'iodure mercurique-même, mais aussi de la présence d'un certain taux d'autres sels de mercure ionisés accompagnant l'iodure mercurique à titre d'impuretés, par exemple d'autres halogénures, nitrate, sulfate, cyanure, etc...

On continue la purification jusqu'au moment où la conductivité de l'espace cathodique n'augmente plus ou très lentement. La solution est alors purifiée des cations d'impuretés, la pureté atteint m6-7N. Une purification supplémentaire est effectuée pour éliminer aussi les anions d'impuretés en procédant de la même façon, mais en inversant la polarité.

Pour obtenir un bon degré de purification, on réalise ainsi 24 cycles de purification pour éliminer les cations et 6 cycles de purification pour éliminer les anions. Dans un autre exemple, on réalise 8 cycles de purification pour éliminer les cations et 2 cycles de purification pour éliminer les anions. On précise que l'on entend par cycle de purification le cycle qui correspond à une électrolyse suivie d'une vidange du compartiment 2, que ce soit dans le cas d'élimination des cations ou dans le cas d'élimination des anions. Dans ces exemples chaque cycle dure environ 7 jours et on récupère à la fin de chaque cycle 65 ml de solution impure par vidange du compartiment 2.

Après ces différents cycles de purification électrolytique, on précipite l'iodure mercurique dissous dans la solution au moyen d'eau ultrapure comme précédemment.

Les teneurs en impuretés du α-HgI₂ ainsi obtenu sont données dans le tableau joint (colonnes 2 et 3).

c) Etape de recristallisation de HgI₂.

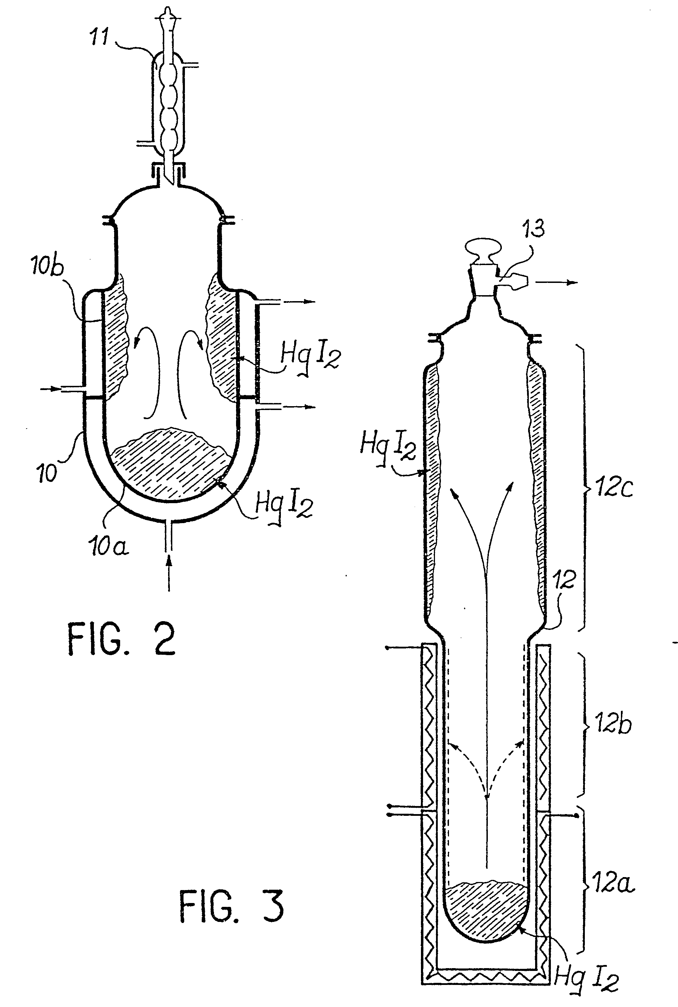

Pour réaliser cette étape, on utilise le réacteur représenté sur la figure 2 qui comprend un récipient en quartz 10 muni d'une double paroi conçue de façon a pouvoir porter les zones 10ₐ et 10ᵦ du réacteur à des températures différentes par circulation d'eau. Le réacteur est muni à sa partie supérieure d'un condenseur à reflux 11. On introduit dans le réacteur 10 mol de l'α-HgI₂ obtenu en a) et 40 mol (1740 ml) d'une solution de DMSO et MeOH ayant un rapport molaire [DMSO]/[DMSO]+[MeOH] de 0,1. On maintient la partie inférieure 10ₐ du réacteur à une température de 65°C par circulation d'eau chaude et l'on obtient ainsi dans la zone 10ₐ une dissolution des cristaux de HgI₂. On maintient la partie supérieure 10ᵦ du réacteur à 15°C par circulation d'eau froide.

Ainsi le α-HgI₂ recristallise en croûte compacte sur les parois de la zone 10ᵦ du réacteur au bout de 5 jours. Le rendement d'un cycle de recristallisation est approximativement de 95%. Lorsque cette recristallisation est terminée, on retire la solution qui reste dans la zone 10ₐ et on récupère l'iodure mercurique recristallisé sur les parois latérales de la zone 10ᵦ, puis on remet ces cristaux à la partie inférieure du réacteur. On introduit alors une nouvelle solution de DMSO et de MeOH et on effectue une nouveau cycle de recristallisation. Dans cet exemple, on a effectué 4 cycles de recristallisation. La teneur en impuretés de α-HgI₂ ainsi purifié est indiquée dans la colonne 4 du tableau joint.

Après le dernier cycle de recristallisation, les cristaux de α-HgI₂ récupérés sur les parois latérales de la zone 10ᵦ du réacteur sont séchés à l'étuve à 80°C, sous un vide de 1350 Pa avant d'être soumis a la dernière étape de purification par distillation sous vide.

d) Etape de distillation sous vide.

Pour réaliser cette étape, on utilise le dispositif représenté sur la figure 3 qui est constitué par un réacteur 12 en quartz de 3 l comprenant 3 zones successives 12a, 12b et 12c. La zone 12a située à la partie inférieure du réacteur peut être portée à une température de 255°C par chauffage électrique. La zone 12b est maintenue à une température de 300°C par un autre chauffage électrique et la troisième zone 12c est refroidie à l'air par convection naturelle. On peut faire le vide dans le réacteur par l'intermédiaire d'une pompe à vide reliée à la partie supérieure 13.

On intoduit au fond du réacteur dans la zone 12a, 5 kg d'α-HgI₂ et on fait un vide de $10^{-4}$ Pa sous pompage continu. On fait fondre les cristaux et on distille à 255°C. La vapeur de HgI₂ se condense sur les parois de la zone supérieure 12c où se forment des cristaux d'α-HgI₂. La distillation dure approximativement 4 heures. Dès que cette distillation est terminée, on détache la couche de cristaux recristallisés sur les parois de la zone 12c et on les replace au fond du réacteur pour réaliser un deuxième cycle de distillation, après avoir éliminé le résidu du premier cycle de distillation restant sur le fond du réacteur et sur les parois de la zone intermédiaire 12b. Le rendement de chaque cycle de distillation est approximativement de 99% et on effectue environ 12 cycles de purification par distillation.

Dans le tableau joint, on a indiqué les teneurs en impuretés de α-HgI₂ obtenu après 12 cycles de purification par distillation.

La liste des éléments considérés représente toutes les impuretés contenues dans α-HgI₂ à l'exception de C, O, N et H qui ne peuvent pas être quantifiés par le type d'analyse utilisé (voir tableau).

Au vu des résultats donnés dans ce tableau, on constate que chaque étape du procédé est très efficace pour diminuer la teneur en impuretés de l'iodure mercurique alpha.

Ainsi, le contenu total en impuretés de l'iodure mercurique alpha obtenu par synthèse en solution étant de 376 ppm, on abaisse celui-ci:

a) à 83 ppm après dix cycles de purification par électrolyse, à 19 ppm après trente cycles de purification par électrolyse,

b) à 53 ppm après quatre cycles de purification par recristallisation, et

c) à 9 ppm après douze cycles de distillation.

Parmi les impuretés non quantifiables par la spectrométrie de masse de loin le plus abondant c'est le C. Dans les cristaux d'α-HgI₂ de synthèse le contenu de C se situe à environ 500 ppm. Après quatre cycles de recristallisation il descend à environ 200 ppm et après douze cycles de distillation il en reste quelques ppm.

Dans ne cas ou l'on réalise successivement les différenées étapes du procédé, on peut obtenir après dix cycles d'électrolyse, quatre cycles de recristallisation et douze cycles de distillation sous vide, une teneur en impureté du α-HgI₂ qui soit inférieure à 1 ppm.

Le procédé de purification selon l'invention parvient à éliminer toutes les impuretés du α-HgI₂ justement par la combinaison des trois étapes de purification décrites plus haut. Ainsi, les impuretés organiques ne s'éliminent pas par électrolyse mais elles s'éliminent par recristallisation et par distillation; le Cu, Ag, Br, Cd ne s'éliminent pas d'une manière efficace par recristallisation mais s'éliminent par électrolyse et par distillation; l'Al, Si, Cr^III, As, V et Zr ne s'éliminent pas efficacement par distillation mais s'éliminent par électrolyse et par recristallisation.

Les cristaux de α-HgI₂ purifiés obtenus par le procédé de l'invention sont conservés dans des flacons en quartz en polyéthylène ou en téflon, sous atmosphère de gaz noble.

Ces cristaux peuvent être utilisés comme source de matière première de pureté et de stoechiométrie satisfaisantes pour obtenir des monocristaux d'iodure mercurique alpha par croissance en solution ou en phase vapeur, répondant aux exigences de qualité imposées par la détection nucléaire.

## 0 118 352

**Tableau**

| Impuretés* | Après a) | Après a)+b) 1 | Après a)+b) 2 | Après a)+c) | Après a)+d) |
|---|---|---|---|---|---|
| Li | 0,4 | 0,1 | – | – | – |
| D | 1 | 0,3 | 0,1 | 0,05 | 0,03 |
| F | 1 | 1 | – | 0,5 | – |
| Na | 20 | 5 | 0,2 | 0,5 | 0,25 |
| Mg | 8 | 2 | 0,3 | 2 | 0,25 |
| Al | 7 | 3,5 | 0,4 | 5 | 2,65 |
| Si | 30 | 14 | < 1 | 3 | 0,90 |
| P | 3 | 0,5 | <0,1 | 1 | 0,05 |
| S | 20 | 4 | – | <2 | 1,05 |
| Cl | 124 | 4 | 0,1 | 3 | 0,10 |
| K | 37 | 9 | 0,6 | 20 | 0,85 |
| Ca | 30 | 11 | 0,5 | 3 | 0,75 |
| Ti | 10 | 1 | <0,3 | 1 | <0,20 |
| V | <0,1 | <0,1 | <0,1 | – | <0,05 |
| Cr | 26 | 4 | 3 | 1 | 0,25 |
| Mn | 0,5 | 0,5 | 0,5 | 0,1 | 0,05 |
| Fe | 25 | 8 | 7 | 6 | 0,60 |
| Nl | 13 | 10 | 3 | 0,3 | 0,40 |
| Co | 0,4 | 0,5 | – | 0,2 | – |
| Cu | 2 | 2 | 1 | 1 | <0,15 |
| Zn | 11 | 2 | 0,5 | <0,1 | – |
| As | 0,4 | – | – | 0,1 | – |
| Br | 0,3 | – | – | 0,1 | – |
| Zr | 2 | – | – | 0,7 | – |
| Ag | 1 | 0,2 | – | 0,7 | – |
| Cd | <2,5 | – | – | < 2 | – |
| Sn | <0,5 | – | – | – | – |
| Ba | – | – | – | – | – |
| Total | 376 | 83 | 19 | 53 | 9 |

1 : 8 cycles de purification des cations et 2 cycles de purification des anions.

2 : 24 cycles de purification des cations et 6 cyles de purification des anions.

* Les résultats sont exprimés en partie par millions de masse (ppm) et ont été obtenus par spectrométrie de masse.

## Revendications

1. Procédé de préparation d'iodure mercurique alpha de haute pureté, caractérisé en ce qu'il consiste:

a) à synthétiser de l'iodure mercurique alpha, et

b) à soumettre l'iodure mercurique alpha ainsi obtenu à un traitement de purification comprenant au moins une étape de distillation sous vide à une température d'au moins 255°C, réalisée dans un réacteur comportant trois zones successives, maintenues à des températures différentes, constituées respectivement par une première zone maintenue à une température de 255°C, dans laquelle on introduit l'iodure mercurique alpha à purifier, une deuxième zone maintenue à une température de 250 à 300°C et une troisième zone maintenue à une temperature inférieure à celles des deux autres zones pour realiser la condensation de l'iodure mercurique alpha évaporé, ladite troisième zone étant refroidie par de l'air et le réacteur étant maintent sous vide au moyen d'une pompe à vide.

2. Procédé selon la revendication 1, caractérisé en ce que l'on réalise la synthèse de l'iodure mercurique alpha par réaction de mercure avec de l'iode, dans une solution d'un sulfoxyde organique contenant du méthanol.

3. Procédé selon la revendication 2, caractérisé en ce que la solution de sulfoxyde organique et de méthanol contient un excès d'iode par rapport à la quantité nécessaire pour obtenir du $HgI_2$ stoechiométrique.

4. Procédé selon l'une quelqonque des revendications 2 et 3, caractérisé en ce que le rapport molaire [sulfoxyde]/[sulfoxyde] + [méthanol] est de 0,6 à 0,8.

5. Procédé selon l'une quelconque des revendications 2 à 4, caractérisé en ce que le sulfoxyde organique est le diméthyl sulfoxyde.

6. Procédé selon l'une quelconque des revendications 1 à 5 caractérisé en ce que le traitement de purification comprend une première étape de purification électrolytique de l'iodure mercurique alpha en solution dans un sulfoxyde organique et une deuxième étape de distillation sous vide.

7. Procédé selon l'une quelconque des revendications 1 à 5, caractérisé en ce que le traitement de purification de l'iodure mercurique alpha comprend une première étape de recristallisation de l'iodure mercurique alpha à partir d'une solution d'iodure mercurique dans un sulfoxyde organique et une deuxième étape de distillation sous vide.

8. Procédé selon l'une quelconque des revendications 1 à 5, caractérisé en ce que le traitement de purification de l'iodure mercurique alpha comprend une première étape de purification électrolytique de l'iodure mercurique en solution dans un sulfoxyde organique, une deuxième étape de recristallisation ce l'iodure mercurique alpha ainsi purifié à partir d'une solution de cet iodure mercurique dans un sulfoxyde organique, et une troisième étape de distillation sous vide.

9. Procédé selon l'une quelconque des revendications 6 et 8, caractérisé en ce que la solution d'iodure mercurique alpha utilisée pour la première étape de purification par électrolyse contient du méthanol.

10. Procédé selon la revendication 9, caractérisé en ce que, dans la solution d'iodure mercurique utilisée pour la purification par électrolyse, le rapport molaire [sulfoxyde]/[sulfoxyde] +[methanol] est de 0,6 à 0,9.

11. Procédé selon l'une quelconque des revendications 7 et 8, caractérisé en ce que la solution d'iodure mercurique alpha utilisée pour l'étape de recristallisation contient du méthanol.

12. Procédé selon la revendication 11, caractérisé en ce que, dans la solution d'iodure mercurique utilisée pour l'étape de recristallisation, le rapport molaire [sulfoxyde]/[sulfoxyde] + [méthanol] est de 0,1 à 0,2.

13. Procédé selon l'une quelconque des revendications 7, 8, 11 et 12, caractérisé en ce que la solution d'iodure mercurique alpha utilisée pour la recristallisation contient un excès d'iode.

14. Procédé selon l'une quelconque des revendications 7, 8, 12 à 13, caractérisé en ce que l'on réalise la recristallisation dans un réacteur comportant deux zones maintenues à des températures différentes, dont une première zone de dissolution chauffée à une température de 60 à 65°C et une seconde zone de cristallisation maintenue à une température inférieure à 20°C.

15. Procédé selon l'une quelconque des revendications 6 à 14, caractérisé en ce que le sulfoxyde organique est le diméthylsulfoxyde.

16. Procédé selon l'une quelconque des revendications 6, 8, 9, 10 et 15, caractérisé en ce que la purification électrolytique s'effectue au moyen d'une anode en mercure et d'une cathode en graphite.

**Patentansprüche**

1. Verfahren zur Herstellung von hochreinem α-Quecksilber(II)jodid, dadurch gekennzeichnet, daß es aus den folgenden Stufen besteht:

a) Synthese des α-Quecksilber(II)jodids und

b) Durchführung einer Reinigungsbehandlung mit dem so erhaltenen α-Quecksilber(II)jodid, die umfaßt mindestens eine Destillationsstufe unter Vakuum bei einer Temperatur von mindestens 255°C, die in einem Reaktionsgefäß mit drei aufeinanderfolgenden Zonen durchgeführt wird, die bei unterschiedlichen Temperaturen gehalten werden und jeweils bestehen aus einer ersten Zone, die bei einer Temperatur von 255°C gehalten wird, in die das zu reinigede α-Quecksilber(II)jodid eingeführt wird, einer zweiten Zone, die bei einer Temperatur von 255 bis 300°C gehalten wird, und einer dritten Zone, die bei einer Temperatur unterhalb derjenigen der beiden anderen Zonen gehalten wird, um die Kondensation des verdampften α-Quecksilber(II)jodids zu bewirken, wobei die dritte Zone mit Luft gekühlt wird und das Reaktionsgefäß mittels einer Vakuumpumpe unter Vakuum gehalten wird.

2. Verfahren nach Anspruch 1, dadurch gekennzeichnet, daß die Synthese von α-Quecksilber(II)jodid durch Umsetzung von Quecksilber mit Jod in einer Lösung eines organischen Sulfoxids, die Methanol enthält, durchgeführt wird.

3. Verfahren nach Anspruch 2, dadurch gekennzeichnet, daß die Lösung von organischem Sulfoxid und Methanol einen Jodüberschuß, bezogen auf die zur Herstellung von stöchiometrischem $HgJ_2$ erforderliche

Menge, enthält.

4. Verfahren nach einem der Ansprüche 2 und 3, dadurch gekennzeichnet, daß das Molverhältnis [Sulfoxid]/[Sulfoxid] [Methanol] 0,6 bis 0,8 beträgt.

5. Verfahren nach einem der Ansprüche 2 bis 4, dadurch gekennzeichnet, daß es sich bei dem organischen Sulfoxid um das Dimethylsulfoxid handelt.

6. Verfahren nach einem der Ansprüche 1 bis 5, dadurch gekennzeichnet, daß die Reinigungsbehandlung umfaßt eine erste Stufe zur elektrolytischen Reinigung des α-Quecksilber(II)jodids in Lösung in einem organischen Sulfoxid und eine zweite Stufe der Destillation unter Vakuum.

7. Verfahren nach einem der Ansprüche 1 bis 5, dadurch gekennzeichnet, daß die Behandlung zur Reinigung von α-Quecksilber(II)jodid umfaßt eine erste Stufe der Umkristallisation des α-Quecksilber(II)jodids aus einer Quecksilber(II)jodidlösung in einem organischen Sulfoxid und eine zweite Stufe der Destillation unter Vakuum.

8. Verfahren nach einem der Ansprüche 1 bis 5, dadurch gekennzeichnet, daß die Behandlung zur Reinigung von α-Quecksilber(II)jodid umfaßt eine erste Stufe der elektrolytischen Reinigung des Quecksilber(II)jodids in Lösung in einem organischen Sulfoxid, eine zweite Stufe der Umkristallisation des so gereinigten α-Quecksilber(II)jodids aus einer Lösung dieses Quecksilber(II)jodids in einem organischen Sulfoxid und eine dritte Stufe der Destillation unter Vakuum.

9. Verfahren nach einem der Ansprüche 6 und 8, dadurch gekennzeichnet, daß die für die erste Stufe der Reinigung durch Elektrolyse verwendete α-Quecksilber(II)jodid-Lösung Methanol enthält.

10. Verfahren nach Anspruch 9, dadurch gekennzeichnet, daß in der für die Reinigung durch die Elektrolyse verwendeten Quecksilber(II)jodid-Lösung das Molverhältnis [Sulfoxid]/[Sulfoxid] + [Methanol] 0,6 bis 0,9 beträgt.

11. Verfahren nach einem der Ansprüche 7 und 8, dadurch gekennzeichnet, daß die für die Stufe der Umkristallisation verwendete α-Quecksilber(II)jodid-Lösung Methanol enthält.

12. Verfahren nach Anspruch 11, dadurch gekennzeichnet, daß in der für die Stufe der Umkristallisation verwendeten Quecksilber(II)jodid-Lösung das Molverhältnis [Sulfoxid]/[Sulfoxid] + [Methanol] 0,1 bis 0,2 beträgt.

13. Verfahren nach einem der Ansprüche 7, 8, 11 und 12, dadurch gekennzeichnet, daß die für die Umkristallisation verwendete α-Quecksilber(II)jodid-Lösung einen Jodüberschuß enthält.

14. Verfahren nach einem der Ansprüche 7, 8, 12 bis 13, dadurch gekennzeichnet, daß man die Umkristallisation in einem Reaktionsgefäß durchführt, das zwei Zonen umfaßt, die bei unterschiedlichen Temperaturen gehalten werden, von denen eine erste Auflösungszone auf eine Temperatur von 60 bis 65°C erhitzt wird und eine zweite Kristallisationszone bei einer Temperatur unterhalb 20°C gehalten wird.

15. Verfahren nach einem der Ansprüche 6 bis 14, dadurch gekennzeichnet, daß es sich bei dem organischen Sulfoxid um Dimethylsulfoxid handelt.

16. Verfahren nach einem der Ansprüche 6, 8, 9, 10 und 15, dadurch gekennzeichnet, daß die elektrolytische Reinigung unter Verwendung einer Quecksilberanode und einer Graphitkathode durchgeführt wird.

## Claims

1. Process for the preparation of high purity alphamercuric iodide, characterized in that it consists:

a) in synthesizing alpha-mercuric iodide, and

b) in subjecting the alpha-mercuric iodide thus obtained to a purification treatment which comprises at least one stage of vacuum distillation at a temperature of at least 255°C, carried out in a reactor containing three successive regions, maintained at different temperatures, consisting of a first region maintained at a temperature of 255°C, into which the alpha-mercuric iodide to be purified is introduced, a second region maintained at a temperature of 255 to 300°C and a third region maintained at a temperature less than those of the two other regions in order to carry out the condensation of the evaporated alpha-mercuric iodide respectively, the said third region being cooled by air and the reactor being maintained under vacuum by means of a vacuum pump.

2. Process according to claim 1, characterized in that the synthesis of the alpha-mercuric iodide is carried out by reaction of mercury with iodine, in an organic sulphoxide solution containing methanol.

3. Process according to claim 2, characterized in that the solution of organic sulphoxide and methanol contains an excess of iodine compared with the quantity required to obtain stoichiometric $HgI_2$.

4. Process according to either of claims 2 and 3, characterized in that the molar ratio [sulphoxide]/[sulphoxide] + [methanol] is from 0.6 to 0.8.

5. Process according to any one of claims 2 to 4, characterized in that the organic sulphoxide is dimethylsulphoxide.

6. Process according to any one of claims 1 to 5, characterized in that the purification treatment comprises a first stage consisting of electrolytic purification of the alpha-mercuric iodide in solution in an organic sulphoxide and a second stage consisting of vacuum distillation.

7. Process according to any one of claims 1 to 5, characterized in that the alpha-mercuric iodide purification treatment comprises a first stage consisting of recrystallization of the alpha-mercuric iodide from a solution of mercuric iodide in an organic sulphoxide and a second stage consisting of vacuum distillation.

9

8. Process according to any one of claims 1 to 5, characterized in that the alpha-mercuric iodide purification treatment comprises a first stage consisting of electrolytic purification of the mercuric iodide in solution in an organic sulphoxide, a second stage consisting of recrystallization of the alpha-mercuric iodide thus purified from a solution of this mercuric iodide in an organic sulphoxide, and a third stage consisting of vacuum distillation.

9. Process according to either of claims 6 and 8, characterized in that the alpha-mercuric iodide solution used for the first stage of purification by electrolysis contains methanol.

10. Process according to claim 9, characterized in that, in the mercuric iodide solution used for the purification by electrolysis, the molar ratio [sulphoxide]/[sulphoxide] + [methanol] is from 0.6 to 0.9.

11. Process according to either of claims 7 and 8, characterized in that the alpha-mercuric iodide solution used for the recrystallization stage contains methanol.

12. Process according to claim 11, characterized in that, in the mercuric iodide solution used for the recrystallization stage, the molar ratio [sulphoxide]/[sulphoxide] + [methanol] is from 0.1 to 0.2.

13. Process according to any one of claims 7, 8, 11 and 12, chhracterized in that the alpha-mercuric iodide solution used for the recrystallization contains an excess of iodine.

14. Process according to any one of claims 7, 8, 12 to 13, characterized in that the recrystallization is carried out in a reactor containing two regions maintained at different temperatures, including a first dissolution region heated to a temperature of 60 to 65° C and a second crystallization region maintained at a temperature less than 20° C.

15. Process according to any one of claims 6 to 14, characterized in that the organic sulphoxide is dimethyl sulphoxide.

16. Process according to any one of claims 6, 8, 9, 10 and 15, characterized in that the electrolytic purification is carried out by means of a mercury anode and a graphite cathode.

FIG. 1

FIG. 2

FIG. 3